(19) Europäisches Patentamt
European Patent Office
Office européen des brevets

(11) **EP 4 685 500 A1**

(12) **EUROPEAN PATENT APPLICATION**
published in accordance with Art. 153(4) EPC

(43) Date of publication:
**28.01.2026  Bulletin 2026/05**

(21) Application number: **24780371.1**

(22) Date of filing: **26.03.2024**

(51) International Patent Classification (IPC):
***G01R 31/28*** (2006.01)      ***G01R 31/302*** (2006.01)
***H01L 21/66*** (2006.01)

(52) Cooperative Patent Classification (CPC):
**G01R 31/28; G01R 31/302; H01L 22/00**

(86) International application number:
**PCT/JP2024/012072**

(87) International publication number:
**WO 2024/204263 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **31.03.2023  JP 2023056888**

(71) Applicant: **Hamamatsu Photonics K.K.
Hamamatsu-shi, Shizuoka 435-8558 (JP)**

(72) Inventor: **CHINONE, Norimichi
Hamamatsu-shi, Shizuoka 435-8558 (JP)**

(74) Representative: **Hoffmann Eitle
Patent- und Rechtsanwälte PartmbB
Arabellastraße 30
81925 München (DE)**

(54)    **INSPECTION DEVICE AND INSPECTION METHOD**

(57)    An inspection device includes: a characteristic signal acquisition unit that outputs a characteristic signal; a noise signal output unit that outputs a noise signal including noise included in a test voltage; a filter for filtering the noise signal; a parameter setting unit for adjusting a parameter of the filter in a direction in which the difference between the noise included in the characteristic signal and the noise included in the noise signal after the filtering decreases; a noise reduction unit that, after the parameter has been adjusted, reduces the noise of the characteristic signal according to a noise signal that has been filtered and outputs the characteristic signal after the noise reduction as information for detecting an abnormal part; and a beam emission unit for emitting a beam at a semiconductor device.

**Fig.1**

**EP 4 685 500 A1**

## Description

### Technical Field

The present disclosure relates to an inspection device and an inspection method. Priority is claimed based on Japanese Patent Application No. 2023-056888, filed on March 31, 2023, the entire content of which is incorporated herein by reference.

### Background Art

Patent Literatures 1 to 3 disclose noise removal in the Optical Beam Induced Resistance Change (OBIRCH) measurement method. Among these, Patent Literatures 2 and 3 disclose methods for removing noise caused by an external power supply device. Patent Literatures 4 to 6 disclose methods for removing noise in failure analysis based on changes in the electrical properties of semiconductor devices due to light irradiation, such as an LIVA/TIVA measurement method or an OBIC measurement method similar to the OBIRCH measurement method.

### Prior Art Documents

### Patent Literature

Patent Literature 1: Japanese Unexamined Patent Publication No. 2012-242157
Patent Literature 2: Japanese Unexamined Patent Publication No. 2020-34440
Patent Literature 3: Japanese Unexamined Patent Publication No. 2021-043156
Patent Literature 4: U.S. Patent Application Publication No. 2002/163352
Patent Literature 5: U.S. Patent No. 6169408 specification
Patent Literature 6: U.S. Patent No. 4588950 specification

## Summary of Invention

### Technical Problem

There are methods such as the OBIRCH measurement method or the OBIC measurement method for analyzing failures and the like based on changes in the electrical properties of an object to be inspected due to beam irradiation. In these methods, noise included in the test voltage or the test current applied to the object to be inspected may be superimposed on the measurement result. Normally, in these methods, the change in the signal obtained from the object to be inspected as a measurement result is very weak. If noise is superimposed on the signal, accurate measurement becomes difficult.

Therefore, it is conceivable to remove noise from the signal of the measurement result, as in the devices or methods disclosed in, for example, Patent Literatures 1 to 6. However, the characteristics (for example, waveform, magnitude, or frequency) of the noise superimposed on the signal of the measurement result change depending on the electrical properties of an objects to be inspected. For example, when measuring a plurality of types of objects to be inspected, there is a variation in the electrical properties of the objects to be inspected. In this case, since the characteristics of the noise superimposed on the measurement result signal change in various ways, it is difficult to effectively reduce the noise.

It is an object of the present disclosure to provide an inspection device and an inspection method capable of effectively reducing noise superimposed on a measurement result signal even when there are variations in the electrical properties of objects to be inspected.

### Means for Solving the Problem

[1] An inspection device according to the present disclosure includes: a characteristic signal acquisition unit that acquires a characteristic signal indicating electrical properties of an inspection target region in an object to be inspected to which a test voltage or a test current is applied; a noise signal output unit that outputs a noise signal including noise included in the test voltage or the test current applied to the inspection target region; a filter that performs filtering on the noise signal; a parameter setting unit that changes a parameter of the filter in such a manner that a difference between noise included in the characteristic signal and noise included in the noise signal after the filtering is reduced; a noise reduction unit that reduces noise in the characteristic signal using the noise signal subjected to the filtering after the parameter is changed by the parameter setting unit and outputs the characteristic signal after noise reduction as information for detecting an abnormal portion in the inspection target region; and a beam irradiation unit that irradiates the inspection target region with a beam when the characteristic signal acquisition unit acquires the characteristic signal before noise reduction that is a basis for the characteristic signal output as the information from the noise reduction unit.

[11] An inspection method according to the present disclosure includes: a first characteristic signal acquisition step of acquiring a first characteristic signal indicating electrical properties of an inspection target region of an object to be inspected while applying a test voltage or a test current to the inspection target region; a first noise signal generation step of generating a first noise signal including noise included in the test voltage or the test current applied to the inspection target region; a first filtering step of performing filtering on the first noise signal using a filter; a parameter setting step of changing a parameter of the filter in such a manner that a difference between noise included in the first characteristic signal and noise included in the first noise signal after the filtering is reduced; a second characteristic signal acquisition step of acquiring a second characteristic signal indicating electrical properties of the inspection target region while applying the test voltage or the test current to the inspection target region and irradiating the inspection target region with a beam; a second noise signal generation step of generating a second noise signal including noise included in the test voltage or the test current applied to the inspection target region; a second filtering step of performing filtering on the second noise signal using the filter after the parameter change; and a noise reduction step of reducing noise in the second characteristic signal using the second noise signal subjected to the filtering and outputting the second characteristic signal after noise reduction as information for detecting an abnormal portion in the inspection target region.

In the inspection device according to [1] above and the inspection method according to [11] above, the parameter of the filter is changed in such a manner that the difference between the noise included in the characteristic signal and the noise included in the noise signal after the filtering is reduced. As a result, when the inspection target region is irradiated with a beam to acquire the characteristic signal, the noise superimposed on the characteristic signal, i.e., the signal of the measurement result, can be reduced by, for example, the difference or ratio between the characteristic signal and the noise signal. According to the device and the method, since the parameter of the filter is changed according to the electrical properties of the object to be inspected, noise can be effectively reduced even if there is variation in the electrical properties of the object to be inspected. Then, based on the characteristic signal with reduced noise, an abnormal portion in the inspection target region can be accurately detected.

[2] In the inspection device according to [1] above, the beam irradiation unit may irradiate the inspection target region with the beam even when the characteristic signal acquisition unit acquires the characteristic signal used to change the parameter in the parameter setting unit. [12] Similarly, in the first characteristic signal acquisition step in the inspection method according to [11] above, the first characteristic signal may be acquired while irradiating the inspection target region with a beam. In this manner, the state of the object to be inspected when acquiring the characteristic signal (first characteristic signal) to change the parameter of the filter can be made the same as the state of the object to be inspected when acquiring the characteristic signal (second characteristic signal) to detect an abnormal portion.

[3] In the inspection device according to [1] above, the beam irradiation unit may not irradiate the inspection target region with the beam when the characteristic signal acquisition unit acquires the characteristic signal used to change the parameter in the parameter setting unit. [13] Similarly, in the first characteristic signal acquisition step in the inspection method according to [11] above, the first characteristic signal may be acquired without irradiating the inspection target region with a beam. In this manner, since the beam irradiation time can be shortened, the risk of damage to the object to be inspected due to beam irradiation can be reduced.

[4] In the inspection device according to any one of [1] to [3] above, the characteristic signal and the noise signal after the filtering that are used in the parameter setting unit may be digital signals, and the parameter setting unit may calculate the parameter by digital calculation. [14] Similarly, in the inspection method according to any one of [11] to [13] above, the first characteristic signal and the first noise signal after the filtering that are used in the parameter setting step may be digital signals, and in the parameter setting step, the parameter may be determined by digital calculation. Thus, it is possible to easily and accurately calculate the parameter.

[5] In the inspection device according to [4] above, the noise signal input to the filter may be a digital signal, and the filter may be a digital filter. [15] Similarly, in the inspection method according to [14] above, the first noise signal and the second noise signal input to the filter may be digital signals, and the filter may be a digital filter. Thus, it is possible to easily change a parameter.

[6] In the inspection device according to [4] or [5] above, the parameter setting unit may include: an evaluation value calculation section that calculates an evaluation value indicating a degree of difference between the noise included in the characteristic signal and the noise included in the noise signal after the filtering; and a parameter calculation section that calculates, based on the evaluation value, the parameter that changes the difference in a reducing direction. [16] Similarly, in the inspection method according to [14] or [15] above, the parameter setting step may include: an evaluation value calculation step of calculating an evaluation value indicating a degree of difference between the noise included in the first characteristic signal and the noise included in the first noise signal after the filtering; and a parameter calculation step of calculating the parameter that changes the difference in a reducing direction based on the evaluation value. Thus, it is possible to suitably calculate a parameter that reduces the difference between the noise included in the characteristic signal and the noise included in the noise signal after filtering.

[7] In the inspection device according to any one of [1] to [6] above, the parameter setting unit may change the parameter so that a difference between the noise included in the characteristic signal and the noise included in the noise signal after the filtering approaches zero. [17] Similarly, in the parameter setting step in the inspection method according to any one of [11] to [16] above, the parameter may be changed so that a difference between the noise included in the first characteristic signal and the noise included in the first noise signal after the filtering approaches zero. Thus, it is possible to reduce noise more effectively.

[8] The inspection device according to any one of [1] to [7] above may further include a control unit that fixes the parameter of the filter after the parameter is changed by the parameter setting unit. [18] Similarly, the inspection method according to any one of [11] to [17] above may further include a step of fixing the parameter of the filter after the parameter setting step and before the second filtering step. Thus, it is possible to stably detect an abnormal portion in the inspection target region.

[9] In the inspection device according to any one of [1] to [8] above, the beam irradiation unit may irradiate with a light beam as the beam. [19] Similarly, in the inspection method according to any one of [11] to [18] above, the beam may be a light beam. Thus, it is possible to change the electrical properties in the inspection target region of the object to be inspected more safely.

[10] In the inspection device according to any one of [1] to [9] above, the characteristic signal acquisition unit may acquire, as the characteristic signal, a current generated in the inspection target region by application of the test voltage or a voltage generated in the inspection target region by application of the test current. [20] Similarly, in the first characteristic signal acquisition step and the second characteristic signal acquisition step in the inspection method according to any one of [11] to [19] above, a current generated in the inspection target region by application of the test voltage or a voltage generated in the inspection target region by application of the test current may be acquired as the first characteristic signal and the second characteristic signal, respectively. Thus, it is possible to accurately detect an abnormal portion in the inspection target region using the OBIRCH measurement method.

## Advantageous Effects of Invention

According to the inspection device and the inspection method according to the present disclosure, even when there is a variation in the electrical properties of objects to be inspected, it is possible to effectively reduce noise superimposed on a measurement result signal.

## Brief Description of Drawings

[FIG. 1] FIG. 1 is a diagram schematically showing the configuration of an inspection device according to an embodiment.

[FIG. 2] FIG. 2 is a block diagram showing a specific example of the configuration of an inspection device.

[FIG. 3] FIG. 3 is a block diagram showing a transversal type filter structure as a structure example of an FIR filter.

[FIG. 4] FIG. 4 is a flowchart showing an example of a method for adjusting a filter coefficient based on an evaluation value.

[FIG. 5] FIG. 5 is a block diagram showing another specific example of the configuration of an inspection device.

[FIG. 6] FIG. 6 is a flowchart showing the operation of an inspection device according to an embodiment.

[FIG. 7] FIG. 7 is a diagram showing a circuit used in the simulation.

[FIG. 8] FIG. 8 is a graph showing a noise waveform.

[FIG. 9] FIG. 9 is a graph showing a time waveform of noise included in a noise signal output from a filter and a time waveform of noise included in a characteristic signal.

[FIG. 10] FIG. 10 is a graph showing a time waveform of noise included in a characteristic signal after a filter parameter is adjusted and a time waveform of noise included in a characteristic signal after noise subtraction.

[FIG. 11] FIG. 11 is a graph showing a part of FIG. 10 in an enlarged view.

[FIG. 12] FIG. 12 is a flowchart showing the operation of an inspection device and an inspection method according to a modification.

## Description of Embodiments

Hereinafter, embodiments of an inspection device and an inspection method according to the present disclosure will be described in detail with reference to the accompanying drawings. In the description of the drawings, the same elements are denoted by the same reference numerals, and the repeated description thereof will be omitted.

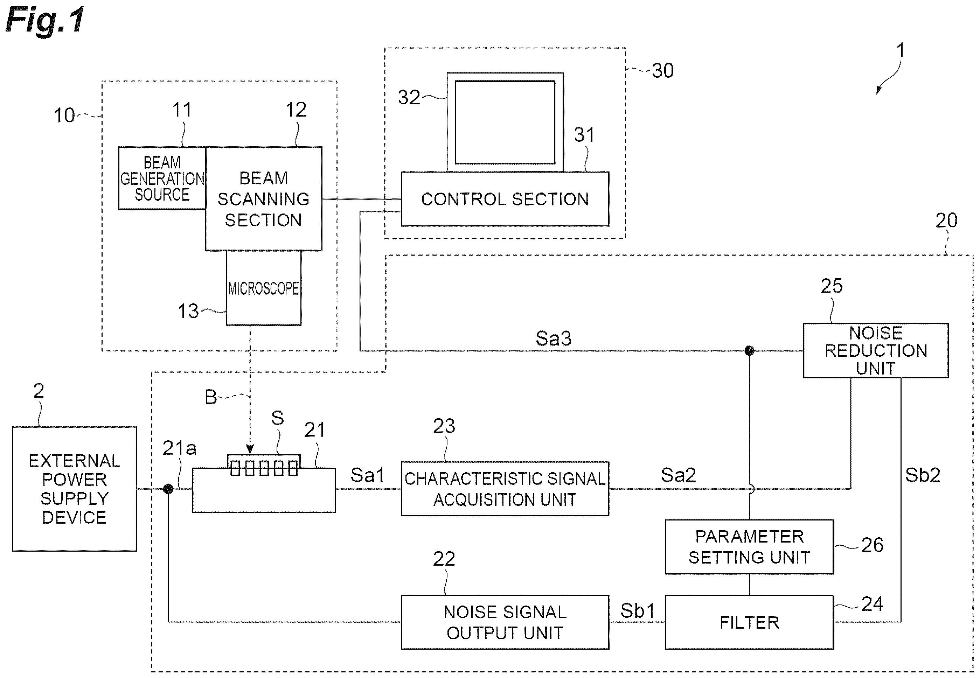

FIG. 1 is a diagram schematically showing the configuration of an inspection device 1 according to an embodiment of the present disclosure. The inspection device 1 according to the present embodiment is a device for inspecting defect locations in a semiconductor device S, which is an object to be inspected, using the OBIRCH method. The semiconductor device S that is an object to be inspected is, for example, an electronic device such as a semiconductor integrated circuit. Alternatively, instead of the semiconductor device S, for example, an electronic component such as a capacitor may be an object to be inspected. In this case, all semiconductor devices S in the following description are to be read as electronic components. In the inspection device 1, a test voltage or a test current is applied to an inspection target region of the semiconductor device S by an external power supply device 2. At the same time, a beam irradiation unit 10 irradiates the inspection target region of the semiconductor device S with a beam B, and scans the inspection target region with the beam B. A characteristic signal Sa1 indicating the electrical properties of the inspection target region is extracted from the semiconductor device S in response to the application of a test voltage or a test current. When the inspection target region of the semiconductor device S is scanned with the beam B, the temperature of a beam irradiated portion changes, and the resistivity of the portion changes. Therefore, when a current flows through the portion without any abnormality, the value of the characteristic signal changes due to irradiation with the beam B. The inspection device 1 detects an abnormal portion in the inspection target region of the semiconductor device S based on the presence or absence or the degree of change in the characteristic signal Sa1 when scanning with the beam B.

The external power supply device 2 is a DC power supply, and converts commercial AC power into DC power. The external power supply device 2 is, for example, a switching power supply. The external power supply device 2 outputs, for example, a test voltage or a test current that is constant over time. The inspection device 1 may include an internal power supply instead of the external power supply device 2.

The inspection device 1 includes the beam irradiation unit 10, an inspection unit 20, and a control unit 30. The beam irradiation unit 10 irradiates and scans the inspection target region of the semiconductor device S with the beam B. The beam B is, for example, a light beam. In one example, it is a laser beam. The light beam does not necessarily have to be coherent light, but may be incoherent light. The beam B does not necessarily have to be a light beam, but may be infrared rays, ultraviolet rays, radiation such as X-rays or gamma rays, an electron beam, or an ultrasonic wave.

In a practical example, the beam irradiation unit 10 includes a beam generation source 11, a beam scanning section 12, and a microscope 13. When the beam B is a laser beam, the beam generation source 11 is, for example, a semiconductor laser or a solid-state laser. When irradiating the semiconductor device S with incoherent light, the beam generation source 11 may be an SLD (Super Luminescent Diode) or an ASE light source. The beam generation source 11 generates and emits the beam B. The beam scanning section 12 is arranged on the optical path of the beam B emitted from the beam generation source 11. The beam B emitted from a beam generation source 11 is incident on the beam scanning section 12. The beam scanning section 12 irradiates the inspection target region with the beam B through the microscope 13, and scans the beam B in a predetermined direction. The beam scanning section 12 performs, for example, a raster scan in a plane perpendicular to the optical axis direction. The microscope 13 focuses the beam B to a small spot diameter. The microscope 13 acquires an image of the irradiated portion by the reflected light of the beam B with which is irradiated.

The inspection unit 20 detects an abnormal portion in the inspection target region of the semiconductor device S based on the characteristic signal Sa1 acquired from the inspection target region of the semiconductor device S. The inspection unit 20 includes a sample stage 21, a noise signal output unit 22, a characteristic signal acquisition unit 23, a filter 24, a noise reduction unit 25, and a parameter setting unit 26.

The semiconductor device S is mounted on the sample stage 21. The semiconductor device S placed on the sample stage 21 is positioned at the focal position of the microscope 13. The sample stage 21 has an input terminal and an output terminal. The input terminal of the sample stage 21 is connected to an output terminal of the external power supply device 2 through a wiring 21a. The semiconductor device S placed on the sample stage 21 is electrically connected to the output terminal of the external power supply device 2 through the sample stage 21. A test voltage or a test current is applied from the external power supply device 2 to the inspection target region of the semiconductor device S through the wiring 21a. The characteristic signal Sa1, which is generated in the inspection target region of the semiconductor device S in response to the application of a test voltage or a test current and indicates the electrical properties of the inspection target region, is output from the output terminal of the sample stage 21. The characteristic signal Sa1 is, for example, an analog signal, and is a voltage signal.

The input terminal of the noise signal output unit 22 is electrically connected to the input terminal of the sample stage 21. That is, the noise signal output unit 22 is electrically connected to the output terminal of the external power supply device 2, and is connected in parallel to the semiconductor device S and the sample stage 21 when viewed from the output terminal of the external power supply device 2. The noise signal output unit 22 receives a test voltage or a test current applied to the inspection target region of the semiconductor device S. The noise signal output unit 22 outputs a noise signal Sb1 that includes noise included in the test voltage or the test current. The noise included in the noise signal Sb1 has approximately the same waveform and approximately the same frequency band as the noise included in the test voltage or the test current. The noise signal Sb1 output from the noise signal output unit 22 is, for example, a digital signal.

The characteristic signal acquisition unit 23 is electrically connected to the output terminal of the sample stage 21. That is, the characteristic signal acquisition unit 23 is connected to the external power supply device 2 through the sample stage 21 and the semiconductor device S. The characteristic signal acquisition unit 23 acquires the characteristic signal Sa1 from the semiconductor device S. The characteristic signal Sa1 is a current generated in the inspection target region when a test voltage is applied, or a voltage generated in the inspection target region when a test current is applied. The characteristic signal acquisition unit 23 outputs a characteristic signal Sa2 corresponding to the characteristic signal Sa1. The characteristic signal Sa2 is, for example, a digital signal indicating the magnitude of the characteristic signal Sa1.

The filter 24 receives the noise signal Sb1 from the noise signal output unit 22. The filter 24 performs filtering on the noise signal Sb1. The filter 24 is, for example, a digital filter. The transfer function of the filter 24 is determined by multiple parameters. The filter 24 outputs a noise signal Sb2 generated by filtering on the noise signal Sb1. When the filter 24 is a digital filter, the noise signal Sb2 is a digital signal.

The noise reduction unit 25 reduces the noise included in the characteristic signal Sa2 using the noise signal Sb2 that has been subjected to filtering by the filter 24. Specifically, the noise included in the characteristic signal Sa2 is reduced by calculating the difference (or ratio) between the noise signal Sb2 and the characteristic signal Sa2. This calculation is, for example, a digital calculation. The noise reduction unit 25 outputs a characteristic signal Sa3 that is a signal obtained by reducing noise from the characteristic signal Sa2. The characteristic signal Sa3 is, for example, a digital signal.

The parameter setting unit 26 adjusts or changes a plurality of parameters of the filter 24. The parameter setting unit 26 adjusts a plurality of parameters of the filter 24 in such a manner that the difference between the noise included in the characteristic signal Sa2 and the noise included in the noise signal Sb2 is reduced. The parameter setting unit 26 may adjust a plurality of parameters of the filter 24 so that the difference between the noise included in the characteristic signal Sa2 and the noise included in the noise signal Sb2 approaches zero. In a practical example, the parameter setting unit 26 receives the characteristic signal Sa3 from the noise reduction unit 25, and adjusts a plurality of parameters of the filter 24 so that the noise included in the characteristic signal Sa3 is reduced (or approaches zero). In one example, the parameter setting unit 26 calculates each of the plurality of parameters by digital calculation.

After the plurality of parameters have been adjusted, the noise reduction unit 25 receives again the noise signal Sb2 that has been subjected to filtering by the filter 24. The noise reduction unit 25 reduces the noise in the characteristic signal Sa2 using the noise signal Sb2. The noise reduction unit 25 outputs the characteristic signal Sa3 after noise reduction as information for detecting an abnormal portion in the inspection target region of the semiconductor device S.

The control unit 30 controls the beam irradiation unit 10 and the inspection unit 20. The control unit 30 presents information to the operator based on the characteristic signal Sa3 output from the noise reduction unit 25. The information is information for detecting an abnormal portion in the inspection target region of the semiconductor device S. In a practical example, the control unit 30 includes a control section 31 and a display section 32. The control section 31 is connected to the beam scanning section 12, the microscope 13, the noise reduction unit 25, the parameter setting unit 26, and the display section 32. The control section 31 controls the scanning of the beam B by the beam scanning section 12, the acquisition of an image of the semiconductor device S by the microscope 13, the adjustment of a plurality of parameters by the parameter setting unit 26, and the display of information by the display section 32. The control section 31 may output a control signal for fixing the plurality of parameters of the filter 24 to the parameter setting unit 26 after the parameter setting unit 26 adjusts the plurality of parameters. The control section 31 displays the distribution of the electrical properties of the semiconductor device S on the display section 32 based on the characteristic signal Sa3 output from the noise reduction unit 25. The electrical properties of the semiconductor device S change with the emission and scanning of the beam B. The display section 32 is, for example, a display device such as a liquid crystal monitor. The control section 31 physically includes: a computer including a CPU (Central Processing Unit) that is a processor, a RAM (Random Access Memory) and a ROM (Read Only Memory) that are storage media, and a communication module; and input/output devices such as a mouse and a keyboard. The control section 31 may include a plurality of computers. The control section 31 may be configured by an FPGA (field programmable gate array), an ASIC (application specific integrated circuit), an SoC (system on a chip), a microcomputer, or the like.

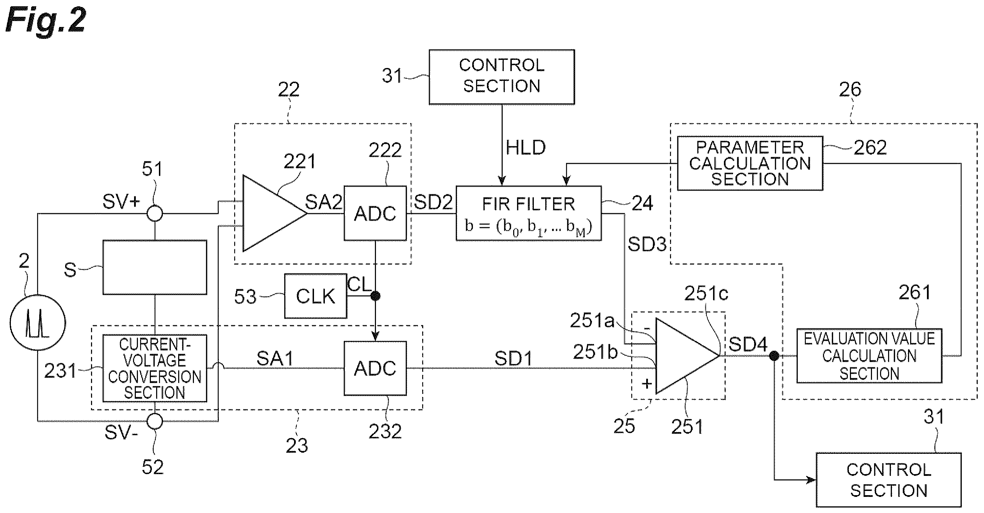

FIG. 2 is a block diagram showing a specific example of the configuration of the inspection device 1. FIG. 2 shows a configuration for applying a test voltage to the inspection target region of the semiconductor device S. In the example shown in FIG. 2, the positive electrode (electric potential SV+) of the external power supply device 2 is connected to a node 51, and the negative electrode (electric potential SV-) of the external power supply device 2 is connected to a node 52. The node 51 is electrically connected to one end of the inspection target region of the semiconductor device S. The node 52 is electrically connected to the other end of the inspection target region of the semiconductor device S. As a result, a voltage between the positive and negative electrodes of the external power supply device 2 is applied to the inspection target region of the semiconductor device S as a test voltage.

The characteristic signal acquisition unit 23 includes a current-to-voltage conversion section 231 and an A/D converter 232. In the illustrated example, the current-to-voltage conversion section 231 is provided between the node 52 and the semiconductor device S. The current-to-voltage conversion section 231 includes, for example, a shunt resistor.

The current-to-voltage conversion section 231 generates a signal SA1 that is an analog signal and a voltage signal. The signal SA1 is a signal corresponding to the magnitude of a current (corresponding to the characteristic signal Sa1 shown in FIG. 1) that is generated in the inspection target region of the semiconductor device S by applying a test voltage. The current-to-voltage conversion section 231 may be provided between the node 51 and the semiconductor device S. The A/D converter 232 is electrically connected to the output terminal of the current-to-voltage conversion section 231. The A/D converter 232 converts the signal SA1 output from the current-to-voltage conversion section 231 into a signal SD1 that is a digital signal. The signal SD1 corresponds to the characteristic signal Sa2 shown in FIG. 1. The A/D converter 232 operates in synchronization with a clock CL output from a clock circuit 53.

The noise signal output unit 22 includes an amplifier 221 and an A/D converter 222. In the example shown in FIG. 2, the amplifier 221 is a differential input amplifier having two input terminals. One input terminal of the two input terminals is electrically connected to the node 51. The other input terminal of the two input terminals is electrically connected to the node 52. In one example, these input terminals are respectively connected (shorted) to the positive and negative electrodes of the external power supply device 2 through an electrical resistance that is substantially zero. In this case, the test voltage output from the external power supply device 2 is applied directly to these input terminals. The amplifier 221 amplifies the voltage between the two input terminals and outputs an amplified signal SA2. The signal SA2 is an analog signal and a voltage signal. The A/D converter 222 is electrically connected to the output terminal of the amplifier 221. The A/D converter 222 converts the signal SA2 output from the amplifier 221 into a signal SD2 that is a digital signal. The signal SD2 corresponds to the noise signal Sb1 shown in FIG. 1. The A/D converter 222 operates in synchronization with the clock CL output from the clock circuit 53. That is, the clock CL is a common clock for the A/D converters 222 and 232.

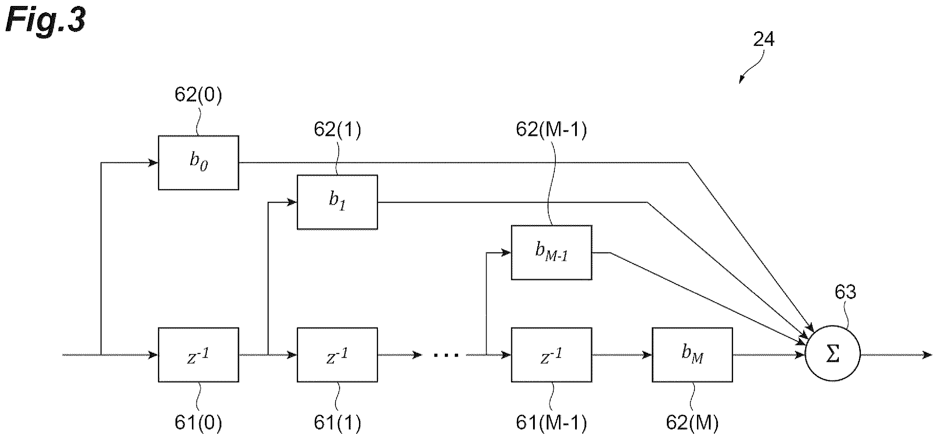

The filter 24 receives the signal SD2 output from the A/D converter 222. The filter 24 filters the signal SD2 and outputs the filtered signal as a signal SD3. The signal SD3 corresponds to the noise signal Sb2 in FIG. 1. The filter 24 is, for example, a Finite Impulse Response (FIR) filter. FIG. 3 is a block diagram showing a transversal-type filter structure as an example of an FIR filter structure. The filter 24 shown in FIG. 3 includes M delay elements 61(0) to 61(M-1), (M+1) filter coefficient blocks 62(0) to 62(M), and one adder 63. The filter coefficient blocks 62(0) to 62(M) include filter coefficients $b_0$ to $b_M$, respectively. The delay elements 61(0) to 61(M-1) are arranged in series in this order. Then, the input signal to the first delay element 61(0) is multiplied by the filter coefficient $b_0$. The output signal from the delay element 61(0) is multiplied by the filter coefficient $b_1$. Thereafter, the output signal from the delay element 61(m) is multiplied by the filter coefficient $b_{m+1}$. A plurality of output signals multiplied by the filter coefficients are all summed by the adder 63. A signal after the addition by the adder 63 becomes the signal SD3 output from the filter 24 shown in FIG. 2. In this example, the plurality of parameters of the filter 24 described above refer to (M+1) filter coefficients $b_0$ to $b_M$.

FIG. 2 is referred to again. The noise reduction unit 25 includes a subtraction section 251. The subtraction section 251 outputs, from an output terminal 251c, a signal remaining after subtracting the signal input to an input terminal 251a from the signal input to an input terminal 251b. The noise reduction unit 25 performs such a calculation digitally. The signal SD1 is input to the input terminal 251b. The signal SD3 is input to the input terminal 251a. Therefore, the subtraction section 251 outputs a signal SD4 indicating the difference between the signal SD1 and the signal SD3. The signal SD4 corresponds to the characteristic signal Sa3 shown in FIG. 1.

The parameter setting unit 26 calculates a plurality of parameters of the filter 24 by iterative calculation. The plurality of parameters of the filter 24 are repeatedly adjusted when a control signal HLD provided from the control section 31 is at a first level (for example, a high level). The plurality of parameters of the filter 24 are fixed when the control signal HLD is at a second level (for example, a low level). The parameter setting unit 26 includes an evaluation value calculation section 261 and a parameter calculation section 262. The evaluation value calculation section 261 calculates an evaluation value. The evaluation value indicates the degree of difference between the noise included in the signal SD1 (that is, the characteristic signal Sa2) and the noise included in the signal SD3 (that is, the noise signal Sb2) after filtering by the filter 24. For example, an evaluation value that decreases as the difference between these noises decreases is used. The time-series data of the signal SD1 is $y = (y_0, y_1, y_2, ..., y_k)$, the time-series data of the signal SD2 is $x = (x_0, x_1, x_2, ..., x_k)$, and the time-series data of the signal SD3 is $x' = (x_0', x_1', x_2', ..., x_k')$. At this time, an evaluation function $f_{Eval}(x', y, N)$ for calculating an evaluation value E is set, for example, as shown in the following Equation (1). N indicates the length of the data sequence used to calculate the evaluation value E. The evaluation function for calculating the evaluation value E is not limited to this. The parameter calculation section 262 calculates, based on the evaluation value E, a plurality of parameters (filter coefficients $b_0$ to $b_M$) that change the difference between these noises in a reducing direction.

[Equation 1]

$$E = f_{Eval}(\mathbf{x'}, \mathbf{y}, N) = \frac{1}{N} \sum_{i=k}^{k-(N-1)} \left( (x_i' - y_i) - \frac{1}{N} \sum_{i=k}^{k-(N-1)} (x_i' - y_i) \right)^2 \qquad \cdot \cdot \cdot \quad (1)$$

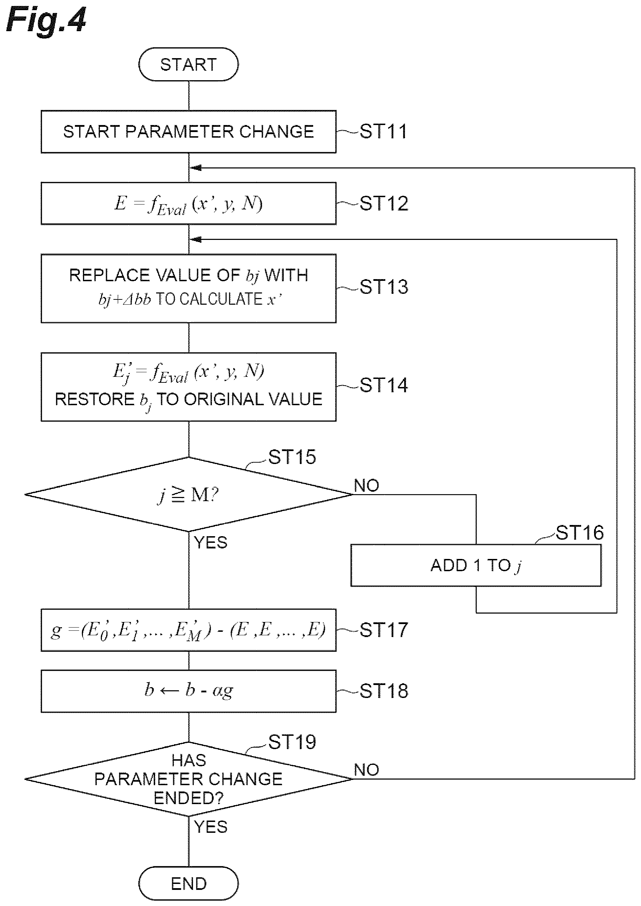

FIG. 4 is a flowchart showing an example of a method for adjusting the filter coefficients $b_0$ to $b_M$ based on the evaluation value E. First, in step ST11, when confirming that the control signal HLD from the control section 31 has reached the first level, the parameter setting unit 26 starts parameter adjustment. In step ST12, the evaluation value calculation section 261 calculates the evaluation value E based on the value of x'-y output from the subtraction section 251. At this time, the filter coefficients of the filter 24 are $b_0$ to $b_M$. As a function for calculating the evaluation value E, for example, the evaluation function $f_{Eval}(x', y, N)$ of the above-described Equation (1) is used. At this time, the variable j is set to an initial value (for example, 0). In step ST13, the parameter calculation section 262 changes the value of the filter coefficient $b_j$ to $b_j + \Delta b$ ($\Delta b$ is a predetermined amount of change). Then, in step ST14, the evaluation value calculation section 261 calculates an evaluation value $E_j'$ based on the value of x'-y output from the subtraction section 251. As a function for calculating the evaluation value $E_j'$, for example, the evaluation function $f_{Eval}(x', y, N)$ of the above-described Equation (1) is also used. Thereafter, the parameter calculation section 262 restores the value of the filter coefficient $b_j$ to the original value. When the variable j does not reach M (step ST15: NO), 1 is added to the variable j (step ST16). Then, the evaluation value calculation section 261 and the parameter calculation section 262 repeat the above steps ST13 and ST14. As a result, when the variable j reaches M (step ST15: YES), time-series data $E' = (E_0', E_1', E_{2'}, ..., E_M')$ of the evaluation value is obtained.

Thereafter, in step ST17, the parameter calculation section 262 calculates time-series data g related to the difference between the time-series data E' of the evaluation value and the original evaluation value E = (E, E, E, ..., E). Then, in step ST18, the parameter calculation section 262 changes the filter coefficient $b = (b_0, b_1, b_2, ..., b_M)$ to b-αg. α is a constant that affects the convergence of the optimization calculation. α can be determined, for example, according to Newton's method.

In step ST19, the parameter setting unit 26 checks the control signal HLD from the control section 31. As long as the control signal HLD is at the first level (step ST19: NO), the parameter setting unit 26 repeats the above-described steps ST12 to ST18. In this manner, the optimal filter coefficient $b = (b_0, b_1, b_2, ..., b_M)$ for bringing the evaluation value E closer to the minimum value is searched for. When the control signal HLD is at the second level (step ST19: YES), the parameter setting unit 26 ends the search and fixes the filter coefficient b.

Thus, the parameter setting unit 26 determines an optimal parameter (filter coefficient b) by alternately repeating the calculation of the evaluation value E by the evaluation value calculation section 261 and the calculation of the parameter (filter coefficient b) by the parameter calculation section 262. The length of the period during which the control signal HLD is at the first level, in other words, the time during which the parameter setting unit 26 searches for the optimal filter coefficient b, is set in advance to a time sufficient for the calculation to converge. The length of the period during which the control signal HLD is at the first level is, for example, five seconds. This time is set in advance according to the processing capabilities of the noise reduction unit 25 and the parameter setting unit 26.

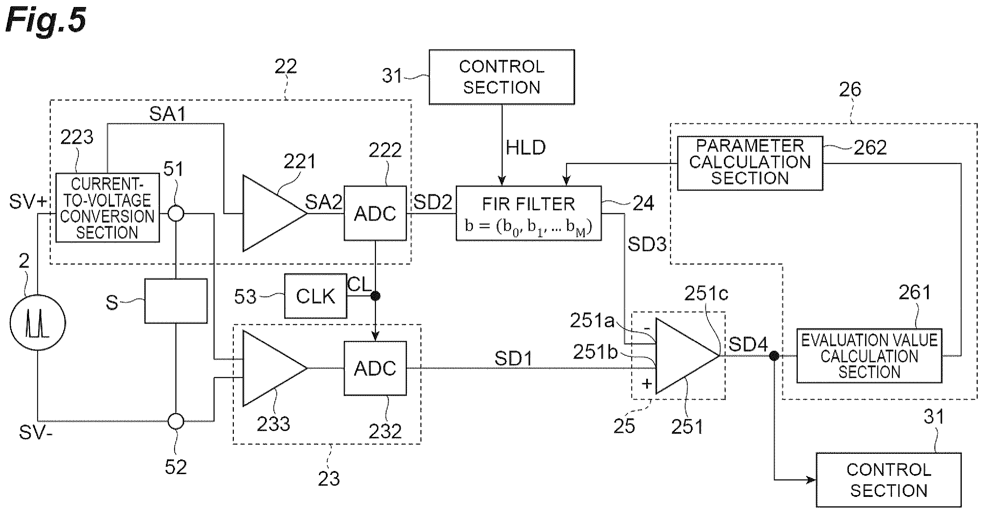

FIG. 5 is a block diagram showing another specific example of the configuration of the inspection device 1. FIG. 5 shows a configuration for applying a test current to the inspection target region of the semiconductor device S. The example shown in FIG. 5 is different from the example shown in FIG. 2 in the following respects, but is identical to the example shown in FIG. 2 in other respects. The characteristic signal acquisition unit 23 does not include the current-to-voltage conversion section 231 shown in FIG. 2, but includes an A/D converter 232 and a differential amplifier 233. The A/D converter 232 is electrically connected to the nodes 51 and 52 through the differential amplifier 233. The A/D converter 232 receives a voltage proportional to the voltage between both ends of the inspection target region of the semiconductor device S. The voltage between both ends of the inspection target region is a voltage generated by application of a test current. The A/D converter 232 outputs the signal SD1 that is a digital signal corresponding to the voltage between both ends. In this example, the noise signal output unit 22 includes the current-to-voltage conversion section 223. The current-to-voltage conversion section 223 is provided between the external power supply device 2 and the semiconductor device S. The current-to-voltage conversion section 223 includes, for example, a shunt resistor. The current-to-voltage conversion section 223 outputs the signal SA1 that is a voltage signal corresponding to the magnitude of the test current. The amplifier 221 is electrically connected to the output terminal of the current-to-voltage conversion section 223. The amplifier 221 amplifies the signal SA1 and outputs the amplified signal SA2.

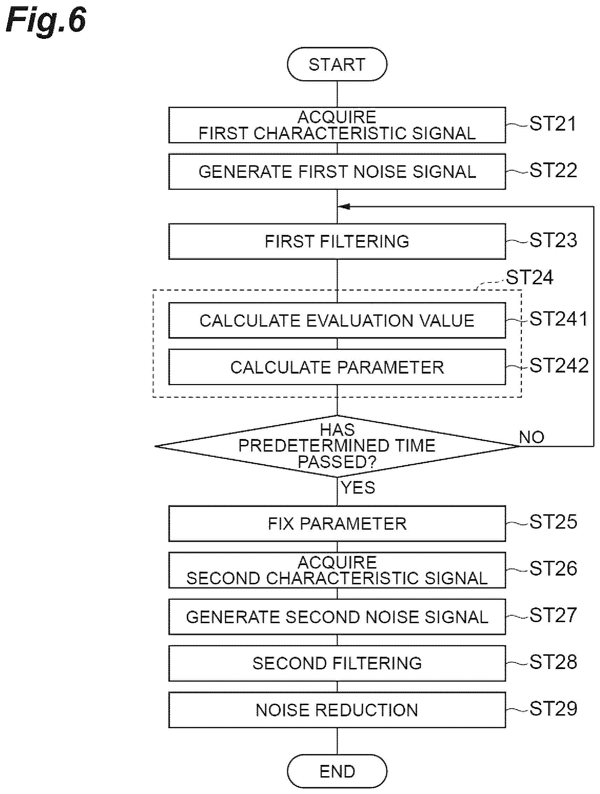

FIG. 6 is a flowchart showing the operation of the inspection device 1 according to the present embodiment. The operation of the inspection device 1 and the inspection method according to the present embodiment will be described with reference to FIG. 6.

First, a first characteristic signal acquisition step ST21, a first noise signal generation step ST22, and a first filtering step ST23 are performed. In the first characteristic signal acquisition step ST21, while applying a test voltage or a test current from the external power supply device 2 to the inspection target region of the semiconductor device S, the characteristic signal acquisition unit 23 acquires the characteristic signal Sa1, which is an analog signal, as a first characteristic signal indicating the electrical properties of the inspection target region. The characteristic signal acquisition unit 23 outputs the characteristic signal Sa2 that is a digital signal corresponding to the characteristic signal Sa1. The characteristic signal Sa2 is used to adjust parameters in a subsequent parameter setting step ST24. In this first characteristic signal acquisition step ST21, the characteristic signal Sa1 is acquired without irradiating the inspection target region with the beam B. In the first noise signal generation step ST22, the noise signal output unit 22 generates the noise signal Sb1, which is a digital signal, as a first noise signal including noise included in the test voltage or the test current applied to the inspection target region of the semiconductor device S. After the first noise signal generation step ST22, in a first filtering step ST23, the filter 24 performs filtering on the noise signal Sb1 and outputs the noise signal Sb2. The filter 24 is, for example, a digital filter.

The order of the first characteristic signal acquisition step ST21 and a step group including the first noise signal generation step ST22 and the first filtering step ST23 is not limited to the above. The first characteristic signal acquisition step ST21 may be performed after the first noise signal generation step ST22 and the first filtering step ST23, or the first characteristic signal acquisition step ST21 may be performed simultaneously with the first noise signal generation step ST22 and the first filtering step ST23.

Then, in a parameter setting step ST24, the parameter setting unit 26 performs a digital calculation to adjust the parameter (filter coefficient b) of the filter 24 in such a manner that the difference between the noise included in the characteristic signal Sa2 and the noise included in the noise signal Sb2 after filtering is reduced. In one example, in the parameter setting step ST24, the parameter is adjusted so that the difference between the noise included in the characteristic signal Sa2 and the noise included in the noise signal Sb2 after filtering approaches zero.

The parameter setting step ST24 includes an evaluation value calculation step ST241 and a parameter calculation step ST242. In the evaluation value calculation step ST241, the evaluation value calculation section 261 calculates the evaluation value E. The evaluation value E indicates the degree of difference between the noise included in the characteristic signal Sa2 and the noise included in the noise signal Sb2 after filtering. In the parameter calculation step ST242, the parameter calculation section 262 calculates, based on the evaluation value E, a parameter that changes the difference in a reducing direction. Until a predetermined time elapses, that is, while the control section 31 keeps the control signal HLD at the first level, the first filtering step ST23, the evaluation value calculation step ST241, and the parameter calculation step ST242 are repeated many times. Therefore, the parameter of the filter 24 gradually converges. After a predetermined time has elapsed, the control section 31 sets the control signal HLD to the second level. Therefore, the above iterative calculations end, and the parameter of the filter 24 is fixed (parameter fixing step ST25).

Then, a second characteristic signal acquisition step ST26, a second noise signal generation step ST27, and a second filtering step ST28 are performed. In the second characteristic signal acquisition step S26, a test voltage or a test current is applied from the external power supply device 2 to the inspection target region of the semiconductor device S, as in the first characteristic signal acquisition step S21. In addition, in the second characteristic signal acquisition step S26, the beam irradiation unit 10 irradiates and scans the inspection target region with the beam B. Then, while applying the test voltage or the test current and performing a scan using the beam B, the characteristic signal acquisition unit 23 acquires again the characteristic signal Sa1, which is an analog signal, as a second characteristic signal indicating the electrical properties of the inspection target region. The characteristic signal Sa1 is a characteristic signal before noise reduction. The characteristic signal before noise reduction serves as the basis for the characteristic signal Sa3 output from the noise reduction unit 25 in a subsequent noise reduction step ST29. The characteristic signal acquisition unit 23 outputs the characteristic signal Sa2 that is a digital signal corresponding to the characteristic signal Sa1. In the second noise signal generation step ST27, the noise signal output unit 22 generates again the noise signal Sb1 as a second noise signal containing the noise included in the test voltage or the test current applied to the inspection target region of the semiconductor device S. After the second noise signal generation step ST27, in the second filtering step ST28, the filter 24 after parameter adjustment performs filtering on the noise signal Sb1 and outputs the noise signal Sb2.

The order of the second characteristic signal acquisition step ST26 and a step group including the second noise signal generation step ST27 and the second filtering step ST28 is not limited to the above. The second characteristic signal acquisition step ST26 may be performed after the second noise signal generation step ST27 and the second filtering step ST28, or the second characteristic signal acquisition step ST26 may be performed simultaneously with the second noise signal generation step ST27 and the second filtering step ST28.

Then, the noise reduction step ST29 is performed. In the noise reduction step ST29, the noise reduction unit 25 reduces the noise in the characteristic signal Sa2 using the noise signal Sb2 that has been subjected to filtering in the second filtering step ST28. The noise reduction unit 25 outputs the characteristic signal Sa3 after noise reduction as information for detecting an abnormal portion in the inspection target region. The control unit 30 presents, to the operator, information for detecting an abnormal portion in the inspection target region of the semiconductor device S based on the characteristic signal Sa3 output from the noise reduction unit 25.

The effects obtained by the inspection device 1 and the inspection method according to the present embodiment described above will be described. In the inspection device 1 and the inspection method according to the present embodiment, the parameter of the filter 24 is adjusted in such a manner that the difference between the noise included in the characteristic signal Sa2 and the noise included in the noise signal Sb2 after filtering is reduced. Therefore, when the inspection target region is irradiated with the beam B to acquire the characteristic signal Sa1, for example, the difference or ratio or the like between the characteristic signal Sa2 and the noise signal Sb2 can be calculated, and the noise superimposed on the characteristic signal Sa3, that is, the signal of the measurement result, can be reduced. According to the inspection device 1 and the inspection method according to the present embodiment, since the parameter of the filter 24 is adjusted according to the electrical properties of the semiconductor device S, noise can be effectively reduced even if there is a variation in the electrical properties of the semiconductor device S. Then, based on the characteristic signal Sa3 with reduced noise, an abnormal portion in the inspection target region can be accurately detected.

As in the present embodiment, in the first characteristic signal acquisition step ST21, the characteristic signal Sa1 may be acquired without irradiating the inspection target region with the beam B from the beam irradiation unit 10. In this case, since the irradiation time of the beam B can be shortened, the risk of damage to the semiconductor device S due to the irradiation of the beam B can be reduced.

As in the present embodiment, the characteristic signal Sa2 and the noise signal Sb2 after filtering used in the parameter setting unit 26 (parameter setting step ST24) are digital signals, and the parameter setting unit 26 (in parameter setting step ST24) may calculate the parameters by digital calculation. Thus, it is possible to easily and accurately calculate the parameters.

As in the present embodiment, the noise signal Sb1 input to the filter 24 may be a digital signal, and the filter 24 may be a digital filter. Thus, it is possible to easily adjust the parameters.

As in the present embodiment, the parameter setting unit 26 may include the evaluation value calculation section 261 that calculates the evaluation value E indicating the degree of difference between the noise included in the characteristic signal Sa2 and the noise included in the noise signal Sb2 after filtering and the parameter calculation section 262 that calculates a parameter that changes the difference in a reducing direction based on the evaluation value E. Similarly, the parameter setting step ST24 may include the evaluation value calculation step ST241 for calculating the evaluation value E indicating the degree of difference between the noise included in the characteristic signal Sa2 and the noise included in the noise signal Sb2 after filtering and the parameter calculation step ST242 for calculating a parameter that changes the difference in a reducing direction based on the evaluation value E. Thus, it is possible to suitably calculate a parameter that reduces the difference between the noise included in the characteristic signal Sa2 and the noise included in the noise signal Sb2 after filtering.

As described above, the parameter setting unit 26 (in parameter setting step ST24) may adjust the parameter so that the difference between the noise included in the characteristic signal Sa2 and the noise included in the noise signal Sb2 after filtering approaches zero. Thus, it is possible to reduce noise more effectively.

As in the present embodiment, the inspection device 1 may include the control section 31 that fixes a parameter of the filter 24 after the parameter is adjusted by the parameter setting unit 26. Similarly, the inspection method may include a parameter fixing step ST25 for fixing the parameter of the filter 24 after the parameter setting step ST24 and before the second filtering step ST28. Thus, it is possible to stably detect an abnormal portion in the inspection target region.

As in the present embodiment, the beam irradiation unit 10 may irradiate the semiconductor device S with a light beam. Similarly, in the inspection method, the beam with which the semiconductor device S is irradiated may be a light beam. In this case, the electrical properties of the semiconductor device S in the inspection target region can be changed more safely than when the beam is a beam (such as an electron beam or an X-ray beam) other than a light beam.

As in the present embodiment, the characteristic signal acquisition unit 23 (in the first characteristic signal acquisition step ST21 and the second characteristic signal acquisition step ST26) may acquire, as the characteristic signal Sa1, a current generated in the inspection target region by the application of a test voltage or a voltage generated in the inspection target region by the application of a test current. Thus, it is possible to accurately detect an abnormal portion in the inspection target region using the OBIRCH measurement method.

The control section 31 may have a storage region for storing the adjusted parameters of the filter 24. Thus, it is possible to read out and use previously adjusted parameters according to the type of the semiconductor device S. As a result, it is possible to reduce the number of parameter adjustments and accordingly shorten the time required for inspection. Depending on the type of the semiconductor device S to be inspected, the adjusted parameters may be provided from the storage region of the control section 31 to the parameter setting unit 26. Alternatively, the control section 31 may store a plurality of adjusted parameter sets corresponding to a plurality of types of semiconductor devices S, and when inspection starts, the parameter setting unit 26 may set the plurality of parameter sets in the filter 24 sequentially so that the most suitable parameter set is finally selected.

Various types of semiconductor devices S may be prepared before inspection, and parameter sets suitable for each semiconductor device S may be collected by steps ST21 to ST24 shown in FIG. 6. Then, the relationship between noise patterns and optimal parameters may be learned through machine learning by using the plurality of collected parameter sets, thereby creating an inference device. As a result, during inspection, the noise signal Sb1 can be input to the inference device and the optimal parameters can be calculated in a short time, so that it is possible to shorten the time required for inspection. Alternatively, by performing steps ST21 to ST24 using the parameters calculated by the inference device as initial values, the time required for parameter adjustment can be shortened, and accordingly, the time required for inspection can be shortened.

[Practical examples]

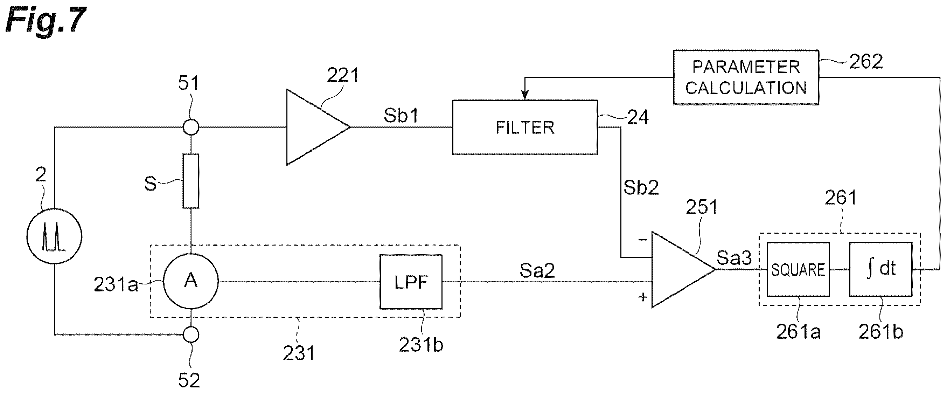

Here, the results of simulating the effects of the above embodiment will be described. FIG. 7 is a diagram showing a circuit used in this simulation. In this circuit, a resistor is provided as the semiconductor device S. As the current-to-voltage conversion section 231, an ammeter 231a and a low-pass filter 231b are provided. The low-pass filter 231b is a delay element in current-to-voltage conversion. As the evaluation value calculation section 261, a squaring element 261a and an integrating element 261b are provided in series.

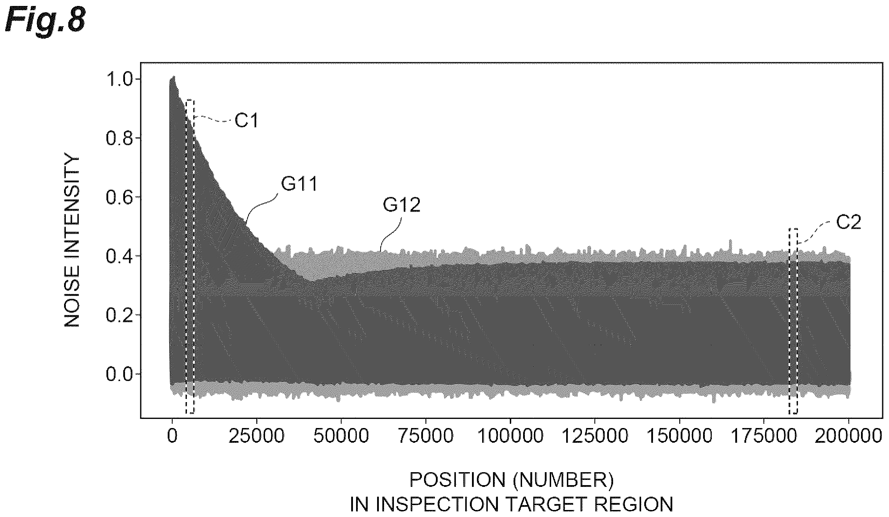

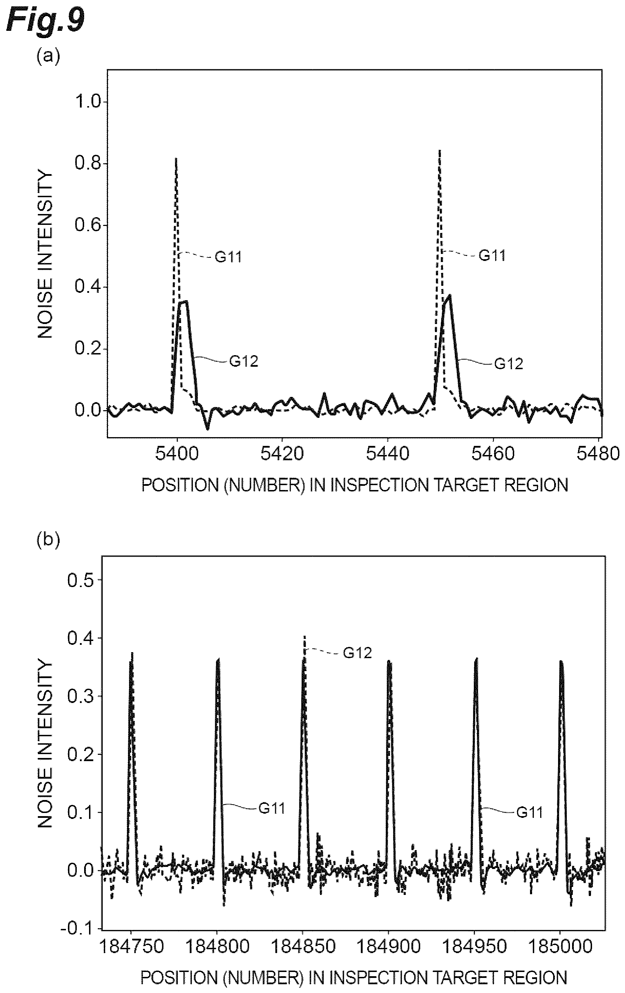

FIG. 8 is a graph showing the waveforms of noise included in the characteristic signal Sa2 and the noise signal Sb2. In FIG. 8, the vertical axis indicates noise intensity (arbitrary unit), and the horizontal axis indicates the irradiation position (number) of the beam B within the inspection target region. In FIG. 8, a noise waveform G11 indicates the waveform of noise included in the noise signal Sb2 output from the filter 24, and a noise waveform G12 indicates the waveform of noise included in the characteristic signal Sa2 output from the current-to-voltage conversion section 231. (a) in FIG. 9 is an enlarged view of a region C1 in FIG. 8. (b) in FIG. 9 is an enlarged view of a region C2 in FIG. 8. In FIGS. 8 and 9, it can be seen that as the irradiation position of the beam B moves, in other words, as time passes, the magnitude of the noise included in the noise signal Sb2 asymptotically approaches the magnitude of the noise included in the characteristic signal Sa2.

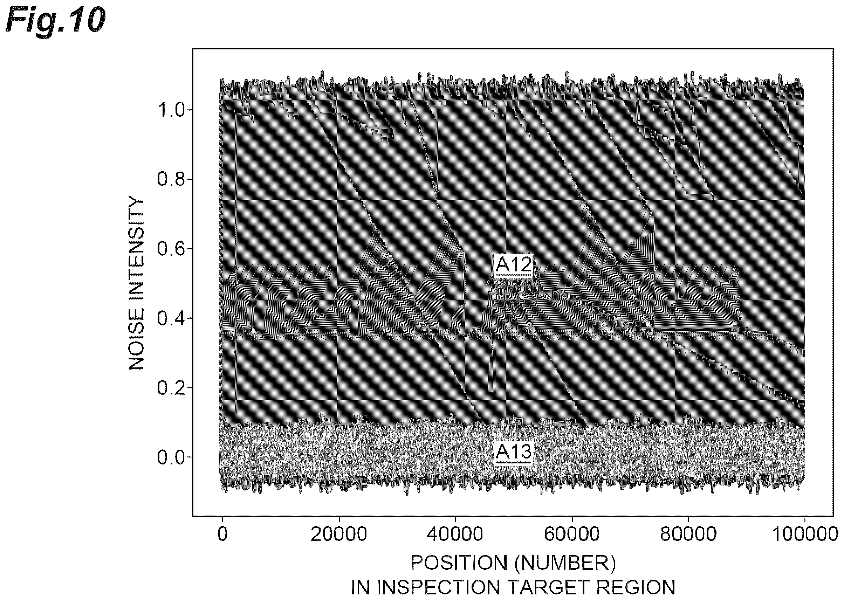

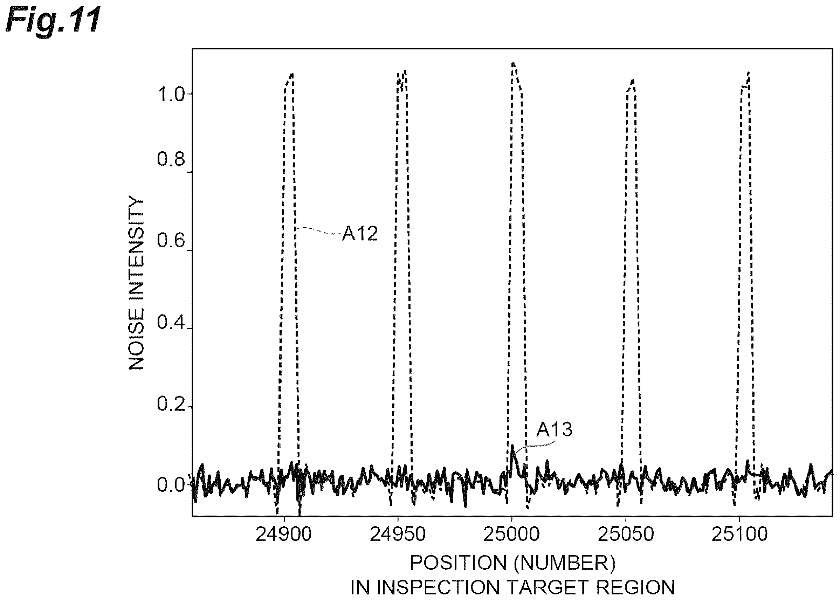

FIG. 10 is a graph showing a time waveform A12 of noise included in the characteristic signal Sa2 after the parameters of the filter 24 are adjusted and a time waveform A13 of noise included in the characteristic signal Sa3 after noise subtraction. In FIG. 10, the vertical axis indicates noise intensity (arbitrary unit), and the horizontal axis indicates the irradiation position (number) of the beam B within the inspection target region. FIG. 11 is a graph showing a part of FIG. 10 in an enlarged view. Referring to FIGS. 10 and 11, it can be seen that spike-like noise included in the characteristic signal Sa2 is effectively reduced in the characteristic signal Sa3.

[Modifications]

In the above embodiment, in the first characteristic signal acquisition step ST21, the characteristic signal Sa1 is acquired without irradiating the inspection target region with the beam B from the beam irradiation unit 10. Without being limited to this embodiment, in the first characteristic signal acquisition step ST21, the characteristic signal Sa1 may be acquired while irradiating and scanning the inspection target region with the beam B from the beam irradiation unit 10. In this manner, the state of the semiconductor device S when acquiring the characteristic signal Sa1 to change the parameters of the filter 24 can be made to be the same as the state of the semiconductor device S when acquiring the characteristic signal Sa1 to detect an abnormal portion in the semiconductor device S. Therefore, for example, even when the average temperature of the entire semiconductor device S increases due to the irradiation of the beam B to change the characteristics of the semiconductor device S, the parameters can be set appropriately.

In the above embodiment, the first filtering step ST23, the evaluation value calculation step ST241, and the parameter calculation step ST242 are repeated until the predetermined time elapses. Then, after the predetermined time has elapsed, the control section 31 sets the control signal HLD to the second level in the parameter fixing step ST25, thereby fixing the parameters of the filter 24. Without being limited to this embodiment, after the evaluation value E has converged within a predetermined range, the control section 31 may set the control signal HLD to the second level in the parameter fixing step ST25 to fix the parameters of the filter 24.

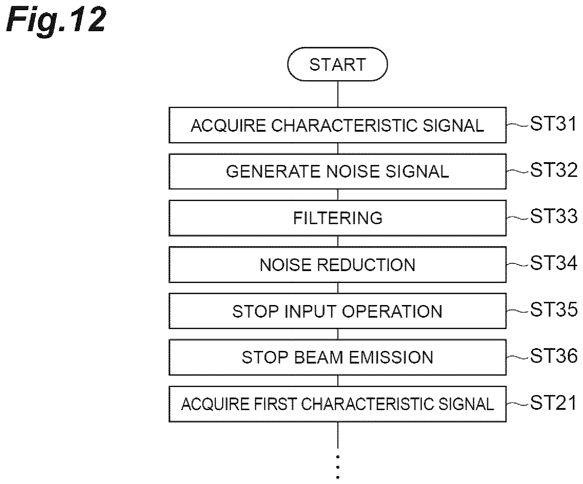

In the above embodiment, after the parameters of the filter 24 are set, information for detecting an abnormal portion in the inspection target region of the semiconductor device S is presented to the operator. Without being limited to this embodiment, when information for detecting an abnormal portion in the inspection target region of the semiconductor device S is presented to the operator, the parameters of the filter 24 may be adjusted each time the operator determines that the information contains a large amount of noise. FIG. 12 is a flowchart showing the operation of the inspection device 1 and its inspection method according to such an embodiment. First, the parameters of the filter 24 are set to predetermined values, and then a characteristic signal acquisition step ST31, a noise signal generation step ST32, a filtering step ST33, and a noise reduction step ST34 are performed. The details of the characteristic signal acquisition step ST31, the noise signal generation step ST32, the filtering step ST33, and the noise reduction step ST34 are similar to those of the second characteristic signal acquisition step ST26, the second noise signal generation step ST27, the second filtering step ST28, and the noise reduction step ST29 described above. Then, when the operator determines that the information for detecting an abnormal portion contains a large amount of noise, the operator performs a stop input operation (step ST35), thereby stopping the irradiation of the beam B (step ST36). Then, the adjustment of the parameters of the filter 24 is started in a state in which the information for detecting an abnormal portion has been presented to the operator. The subsequent operations are similar to those shown in FIG. 6.

In the embodiment shown in FIG. 12, the stop input operation in step ST35 may be determined by the control section 31 instead of the operator. That is, when the control section 31 determines that the information for detecting an abnormal portion contains a large amount of noise, a stop input operation may be performed, thereby stopping the irradiation of the beam B. The control section 31 may determine whether there is a large amount of noise based on the magnitude of high-frequency components contained in the characteristic signal Sa3 (or contained in the information). Alternatively, when the control section 31 determines that the information for detecting an abnormal portion contains a

**EP 4 685 500 A1**

large amount of noise, the control section 31 may propose to the operator to adjust the parameters of the filter 24, and the parameter adjustment may be started in response to a stop input operation from the operator.

In the above embodiment, while the parameters of the filter 24 are being adjusted, the characteristic signal Sa3 after noise reduction is not output as information for detecting an abnormal portion. The present invention is not limited to this embodiment, the characteristic signal Sa3 after noise reduction may be output as information for detecting an abnormal portion while the parameters of the filter 24 are being adjusted. In other words, the presentation of the information for detecting an abnormal portion to the operator and the adjustment of the parameters of the filter 24 may be performed in parallel.

The inspection device and the inspection method according to the present disclosure are not limited to the embodiments described above, and various other modifications can be made. For example, in the above embodiment, an FIR filter is exemplified as the filter 24. Although the FIR filter is a stable filter in principle, the type of the filter 24 is not limited to this. For example, the filter 24 may be a moving average filter or an infinite impulse response (IIR) filter. The moving average filter is a stable filter, as is the FIR filter. The IIR filter can realize more complex filters.

In the above embodiment, a configuration is exemplified in which the characteristic signal Sa2 and the noise signal Sb1 are digital signals and the filter 24 is a digital filter. The inspection device and the inspection method according to the present disclosure are not limited to this configuration. The characteristic signal Sa2 and the noise signal Sb1 may be analog signals, and the filter 24 may be an analog filter.

In the above embodiment, an example is described in which the inspection device and the inspection method perform OBIRCH measurement. The inspection device and the inspection method according to the present disclosure may perform OBIC measurement in which a photovoltaic current is generated in a semiconductor by beam irradiation. Even in this case, the same effects as those described above can be achieved.

**List of Reference Signs**

1: inspection device, 2: external power supply device, 10: beam irradiation unit, 11: beam generation source, 12: beam scanning section, 13: microscope, 20: inspection unit, 21: sample stage, 21a: wiring, 22: noise signal output unit, 23: characteristic signal acquisition unit, 24: filter, 25: noise reduction unit, 26: parameter setting unit, 30: control unit, 31: control section, 32: display section, 51, 52: node, 53: clock circuit, 61(0) to 61(M-1): delay element, 62(0) to 62(M): filter coefficient block, 63: adder, 221: amplifier, 222, 232: A/D converter, 223, 231: current-to-voltage conversion section, 231a: ammeter, 231b: low-pass filter, 233: differential amplifier, 251: subtraction section, 251a, 251b: input terminal, 251c: output terminal, 261: evaluation value calculation section, 261a: squaring element, 261b: integrating element, 262: parameter calculation section, A11, A12, A13: time waveform, B: beam, CL: clock, G11, G12: noise waveform, HLD: control signal, S: semiconductor device, S21: first characteristic signal acquisition step, S26: second characteristic signal acquisition step, Sa1, Sa2, Sa3: characteristic signal, SA1, SA2, SD1, SD2, SD3, SD4: signal, Sb1, Sb2: noise signal.

**Claims**

1.    An inspection device, comprising:

a characteristic signal acquisition unit that acquires a characteristic signal indicating electrical properties of an inspection target region in an object to be inspected to which a test voltage or a test current is applied;
a noise signal output unit that outputs a noise signal including noise included in the test voltage or the test current applied to the inspection target region;
a filter that performs filtering on the noise signal;
a parameter setting unit that changes a parameter of the filter in such a manner that a difference between noise included in the characteristic signal and noise included in the noise signal after the filtering is reduced;
a noise reduction unit that reduces noise in the characteristic signal using the noise signal subjected to the filtering after the parameter is changed by the parameter setting unit and outputs the characteristic signal after noise reduction as information for detecting an abnormal portion in the inspection target region; and
a beam irradiation unit that irradiates the inspection target region with a beam when the characteristic signal acquisition unit acquires the characteristic signal before noise reduction that is a basis for the characteristic signal output as the information from the noise reduction unit.

2.    The inspection device according to claim 1,
wherein the beam irradiation unit irradiates the inspection target region with the beam even when the characteristic signal acquisition unit acquires the characteristic signal used to change the parameter in the parameter setting unit.

12

3. The inspection device according to claim 1,
wherein the beam irradiation unit does not irradiate the inspection target region with the beam when the characteristic signal acquisition unit acquires the characteristic signal used to change the parameter in the parameter setting unit.

4. The inspection device according to any one of claims 1 to 3,

   wherein the characteristic signal and the noise signal after the filtering that are used in the parameter setting unit are digital signals, and
   the parameter setting unit determines the parameter by digital calculation.

5. The inspection device according to claim 4,
wherein the noise signal input to the filter is a digital signal, and the filter is a digital filter.

6. The inspection device according to claim 4 or 5,

   wherein the parameter setting unit includes: an evaluation value calculation section that calculates an evaluation value indicating a degree of difference between the noise included in the characteristic signal and the noise included in the noise signal after the filtering; and
   a parameter calculation section that calculates, based on the evaluation value, the parameter that changes the difference in a reducing direction.

7. The inspection device according to any one of claims 1 to 6,
wherein the parameter setting unit changes the parameter so that a difference between the noise included in the characteristic signal and the noise included in the noise signal after the filtering approaches zero.

8. The inspection device according to any one of claims 1 to 7, further comprising:
a control unit that fixes the parameter of the filter after the parameter is changed by the parameter setting unit.

9. The inspection device according to any one of claims 1 to 8,
wherein the beam irradiation unit irradiates with a light beam as the beam.

10. The inspection device according to any one of claims 1 to 9,
wherein the characteristic signal acquisition unit acquires, as the characteristic signal, a current generated in the inspection target region by application of the test voltage or a voltage generated in the inspection target region by application of the test current.

11. An inspection method, comprising:

    a first characteristic signal acquisition step of acquiring a first characteristic signal indicating electrical properties of an inspection target region of an object to be inspected while applying a test voltage or a test current to the inspection target region;
    a first noise signal generation step of generating a first noise signal including noise included in the test voltage or the test current applied to the inspection target region;
    a first filtering step of performing filtering on the first noise signal using a filter;
    a parameter setting step of changing a parameter of the filter in such a manner that a difference between noise included in the first characteristic signal and noise included in the first noise signal after the filtering is reduced;
    a second characteristic signal acquisition step of acquiring a second characteristic signal indicating electrical properties of the inspection target region while applying the test voltage or the test current to the inspection target region and irradiating the inspection target region with a beam;
    a second noise signal generation step of generating a second noise signal including noise included in the test voltage or the test current applied to the inspection target region;
    a second filtering step of performing filtering on the second noise signal using the filter after the parameter change; and
    a noise reduction step of reducing noise in the second characteristic signal using the second noise signal subjected to the filtering, and outputting the second characteristic signal after noise reduction as information for detecting an abnormal portion in the inspection target region.

12. The inspection method according to claim 11,

wherein, in the first characteristic signal acquisition step, the first characteristic signal is acquired while irradiating the inspection target region with a beam.

13. The inspection method according to claim 11,
wherein, in the first characteristic signal acquisition step, the first characteristic signal is acquired without irradiating the inspection target region with a beam.

14. The inspection method according to any one of claims 11 to 13,

wherein the first characteristic signal and the first noise signal after the filtering that are used in the parameter setting step are digital signals, and
in the parameter setting step, the parameter is calculated by digital calculation.

15. The inspection method according to claim 14,
wherein the first noise signal and the second noise signal input to the filter are digital signals, and the filter is a digital filter.

16. The inspection method according to claim 14 or 15,

wherein the parameter setting step includes: an evaluation value calculation step of calculating an evaluation value indicating a degree of difference between the noise included in the characteristic signal and the noise included in the first noise signal after the filtering; and
a parameter calculation step of calculating the parameter that changes the difference in a reducing direction based on the evaluation value.

17. The inspection method according to any one of claims 11 to 16,
wherein, in the parameter setting step, the parameter is changed so that a difference between the noise included in the first characteristic signal and the noise included in the first noise signal after the filtering approaches zero.

18. The inspection method according to any one of claims 11 to 17, further comprising:
a step of fixing the parameter of the filter after the parameter setting step and before the second filtering step.

19. The inspection method according to any one of claims 11 to 18,
wherein the beam is a light beam.

20. The inspection method according to any one of claims 11 to 19,
wherein, in the first characteristic signal acquisition step and the second characteristic signal acquisition step, a current generated in the inspection target region by application of the test voltage or a voltage generated in the inspection target region by application of the test current is acquired as the first characteristic signal and the second characteristic signal.

Fig.1

EP 4 685 500 A1

# Fig.2

Fig.3

EP 4 685 500 A1

# Fig.4

```
                    ┌─────────────┐
                    │    START    │
                    └─────────────┘
                           │
        ┌──────────────────────────────────────┐
        │      START PARAMETER CHANGE           │──ST11
        └──────────────────────────────────────┘
                           │
        ┌──────────────────────────────────────┐
        │         E = f_Eval (x', y, N)         │──ST12
        └──────────────────────────────────────┘
                           │
        ┌──────────────────────────────────────┐
        │     REPLACE VALUE OF bj WITH          │──ST13
        │     bj+Δbb TO CALCULATE x'            │
        └──────────────────────────────────────┘
                           │
        ┌──────────────────────────────────────┐
        │      E'_j = f_Eval (x', y, N)         │──ST14
        │     RESTORE b_j TO ORIGINAL VALUE     │
        └──────────────────────────────────────┘
                           │
                      ╱─────────╲  ST15
                     ╱  j ≧ M?    ╲────NO──────┐
                     ╲           ╱             │
                      ╲─────────╱        ┌──────────────┐ ST16
                        │ YES            │  ADD 1 TO j  │
                        │                └──────────────┘
        ┌──────────────────────────────────────┐
        │  g =(E'_0,E'_1,...,E'_M) - (E,E,...,E)│──ST17
        └──────────────────────────────────────┘
                           │
        ┌──────────────────────────────────────┐
        │             b ← b - αg               │──ST18
        └──────────────────────────────────────┘
                           │
                      ╱─────────╲  ST19
                     ╱   HAS      ╲
                    ╱ PARAMETER    ╲───NO
                    ╲ CHANGE ENDED?╱
                     ╲            ╱
                      ╲─────────╱
                        │ YES
                    ┌─────────────┐
                    │     END     │
                    └─────────────┘
```

$E = f_{Eval}(x', y, N)$ ──ST12

REPLACE VALUE OF $bj$ WITH $bj+\Delta bb$ TO CALCULATE $x'$ ──ST13

$E'_j = f_{Eval}(x', y, N)$ RESTORE $b_j$ TO ORIGINAL VALUE ──ST14

$j \geqq M?$ ──ST15

ADD 1 TO $j$ ──ST16

$g = (E'_0, E'_1, ..., E'_M) - (E, E, ..., E)$ ──ST17

$b \leftarrow b - \alpha g$ ──ST18

Fig.5

## Fig.6

```
                    ┌─────────┐
                    │  START  │
                    └─────────┘
                         │
        ┌────────────────────────────────┐
        │            ACQUIRE             │── ST21
        │   FIRST CHARACTERISTIC SIGNAL  │
        └────────────────────────────────┘
        ┌────────────────────────────────┐
        │   GENERATE FIRST NOISE SIGNAL  │── ST22
        └────────────────────────────────┘
                         │
                         ▼
        ┌────────────────────────────────┐
        │        FIRST FILTERING         │── ST23
        └────────────────────────────────┘
                                          ·····ST24
        ┌ ─ ─ ─ ─ ─ ─ ─ ─ ─ ─ ─ ─ ─ ─ ─ ┐
          ┌────────────────────────────┐
        │ │  CALCULATE EVALUATION VALUE │─┼─ ST241
          └────────────────────────────┘
        │ ┌────────────────────────────┐ │
          │     CALCULATE PARAMETER    │─┼─ ST242
        │ └────────────────────────────┘
        └ ─ ─ ─ ─ ─ ─ ─ ─ ─ ─ ─ ─ ─ ─ ─ ┘
                         │
                   ╱──────────────╲
                  ╱      HAS        ╲        NO
        ◄────────◄ PREDETERMINED TIME ►─────────┐
                  ╲    PASSED?       ╱           │
                   ╲──────────────╱              │
                         │ YES                   │
        ┌────────────────────────────────┐       │
        │          FIX PARAMETER         │── ST25 │
        └────────────────────────────────┘
        ┌────────────────────────────────┐
        │            ACQUIRE             │── ST26
        │  SECOND CHARACTERISTIC SIGNAL  │
        └────────────────────────────────┘
        ┌────────────────────────────────┐
        │  GENERATE SECOND NOISE SIGNAL  │── ST27
        └────────────────────────────────┘
        ┌────────────────────────────────┐
        │        SECOND FILTERING        │── ST28
        └────────────────────────────────┘
        ┌────────────────────────────────┐
        │        NOISE REDUCTION         │── ST29
        └────────────────────────────────┘
                         │
                    ┌─────────┐
                    │   END   │
                    └─────────┘
```

Fig.7

EP 4 685 500 A1

*Fig.8*

POSITION (NUMBER)
IN INSPECTION TARGET REGION

## Fig.9

(a)

(b)

Fig.10

NOISE INTENSITY

POSITION (NUMBER)
IN INSPECTION TARGET REGION

A12

A13

*Fig.11*

## Fig.12

```
                    START

ACQUIRE CHARACTERISTIC SIGNAL        ST31

    GENERATE NOISE SIGNAL            ST32

         FILTERING                   ST33

      NOISE REDUCTION                ST34

    STOP INPUT OPERATION             ST35

    STOP BEAM EMISSION               ST36

ACQUIRE FIRST CHARACTERISTIC SIGNAL  ST21

              :
```

## INTERNATIONAL SEARCH REPORT

| International application No. |
|---|
| **PCT/JP2024/012072** |

| A. | CLASSIFICATION OF SUBJECT MATTER |
|---|---|

*G01R 31/28*(2006.01)i; *G01R 31/302*(2006.01)i; *H01L 21/66*(2006.01)i
FI:    G01R31/28 L; G01R31/302; H01L21/66 C

According to International Patent Classification (IPC) or to both national classification and IPC

| B. | FIELDS SEARCHED |
|---|---|

Minimum documentation searched (classification system followed by classification symbols)

G01R31/28; G01R31/302; H01L21/66

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2021-43156 A (HAMAMATSU PHOTONICS K.K.) 18 March 2021 (2021-03-18) paragraphs [0001]-[0122], fig. 1-13 | 1-20 |
| Y | WO 2012/115149 A1 (MITSUBISHI HEAVY INDUSTRIES, LTD.) 30 August 2012 (2012-08-30) paragraphs [0038]-[0066], fig. 2 | 1-20 |
| Y | CD-ROM of the specification and drawings annexed to the request of Japanese Utility Model Application No. 6261/1993 (Laid-open No. 64612/1994) (GE YOKOGAWA MEDICAL SYSTEMS LTD.) 13 September 1994 (1994-09-13), fig. 1-7 | 1-20 |
| Y | US 5229765 A (HALLIBURTON LOGGING SERVICES, INC.) 20 July 1993 (1993-07-20) fig. 1-3 | 1-20 |
| Y | WO 2005/105580 A2 (MARS, INCORPORATED) 10 November 2005 (2005-11-10) fig. 3 | 1-20 |

☐ Further documents are listed in the continuation of Box C.     ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **28 May 2024** | **11 June 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/012072**

| Patent document cited in search report | | | Publication date (day/month/year) | Patent family member(s) | | | Publication date (day/month/year) |
|---|---|---|---|---|---|---|---|
| JP | 2021-43156 | A | 18 March 2021 | US | 2022/0308108 | A1 | |
| | | | | paragraphs [0001]-[0134], fig. 1-13 | | | |
| | | | | WO | 2021/049313 | A1 | |
| | | | | EP | 4027374 | A1 | |
| | | | | CN | 114364995 | A | |
| | | | | KR | 10-2022-0059935 | A | |
| | | | | JP | 6824351 | B1 | |
| WO | 2012/115149 | A1 | 30 August 2012 | JP | 2012-177612 | A | |
| JP | 6-64612 | U1 | 13 September 1994 | (Family: none) | | | |
| US | 5229765 | A | 20 July 1993 | (Family: none) | | | |
| WO | 2005/105580 | A2 | 10 November 2005 | GB | 2413632 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023056888 A
- JP 2012242157 A
- JP 2020034440 A
- JP 2021043156 A
- US 2002163352
- US 6169408 B
- US 4588950 A